# EUROPEAN PATENT APPLICATION

(11) **EP 4 221 478 A1**
(43) Date of publication of application: **02.08.2023**
(21) Application number: 23153308.4
(22) Date of filing: 25.01.2023
(51) Int. Cl.: H05K 7/20, H05K 7/14, B25J 9/16

(54) **ROBOT CONTROL APPARATUS**

(30) Priority: 31.01.2022 JP 2022013744
(71) Applicant: Seiko Epson Corporation, Tokyo 160-8801 (JP)
(72) Inventor: TERANAKA, Ryosuke, Suwa-shi, Nagano, 392-8502 (JP)
(74) Representative: MERH-IP Matias Erny Reichl Hoffmann Patentanwälte PartG mbB

(57) **Abstract**

A robot control apparatus controlling a robot includes a control board for controlling operation of the robot, a housing including a plurality of plate materials containing a first plate material and a second plate material and housing the control board in a space surrounded by the plurality of plate materials, an intake port for taking air into the housing, an exhaust port for exhausting the air within the housing to outside, and a cable coupling portion coupling a cable for communication with the robot, wherein the intake port, the exhaust port, and the cable coupling portion are provided in the first plate material, and the second plate material includes an installation surface facing an object on which the housing is installed.

## Description

The present application is based on, and claims priority from JP Application Serial Number 2022-013744, filed January 31, 2022, the disclosure of which is hereby incorporated by reference herein in its entirety.

### BACKGROUND

### 1. Technical Field

The present disclosure relates to a robot control apparatus.

### 2. Related Art

Recently, in factories, due to rises in labor costs and shortages of human resources, work that had been manually performed has been acceleratingly automated by various robots and robot peripherals thereof. The robots include e.g. a robot disclosed in JP-A-2011-194480.

The robot disclosed in JP-A-2011-194480 includes a base and a robot arm coupled to the base. Further, the operation of the robot is controlled by a controller. The controller disclosed in JP-A-2011-194480 includes a control board and a housing that houses the control board. Further, the housing has an intake port and an exhaust port for cooling and a cable coupling portion to which a cable coupling the robot and the controller is coupled.

However, in the controller disclosed in JP-A-2011-194480, the cable coupling portion and the intake port are provided in a back surface and the exhaust portion is provided in a front surface. As described above, the cable coupling portion, the intake port, and the exhaust port are not collectively provided and, when the controller is installed, it is necessary not to bring the cable coupling portion, the intake port, and the exhaust port into close contact with a wall and there are a lot of restrictions in installation position.

### SUMMARY

The present disclosure has been achieved to solve at least a part of the above described problem and can be realized by the following configuration.

A robot control apparatus according to an aspect of the present disclosure is a robot control apparatus controlling a robot including a control board for controlling operation of the robot, a housing including a plurality of plate materials containing a first plate material and a second plate material and housing the control board in a space surrounded by the plurality of plate materials, an intake port for taking air into the housing, an exhaust port for exhausting the air within the housing to outside, and a cable coupling portion coupling a cable for communication with the robot, wherein the intake port, the exhaust port, and the cable coupling portion are provided in the first plate material, and the second plate material includes an installation surface facing an object on which the housing is installed.

### BRIEF DESCRIPTION OF THE DRAWINGS

FIG. 1 is a side view showing a robot controlled by a robot control apparatus in a first embodiment of the present disclosure.
FIG. 2 is a partial sectional view showing an interior of a second arm of a robot arm shown in FIG. 1.
FIG. 3 is a perspective view of the robot control apparatus shown in FIG. 1.
FIG. 4 is a front view of the robot control apparatus shown in FIG. 1.
FIG. 5 is a partial sectional view of the robot control apparatus shown in FIG. 1.
FIG. 6 is a partial sectional view of the robot control apparatus shown in FIG. 1.
FIG. 7 is a partial sectional view of a robot control apparatus according to a second embodiment of the present disclosure.

### DESCRIPTION OF EXEMPLARY EMBODIMENTS

As below, a robot control apparatus of the present disclosure will be explained in detail based on preferred embodiments shown in the accompanying drawings.

### First Embodiment

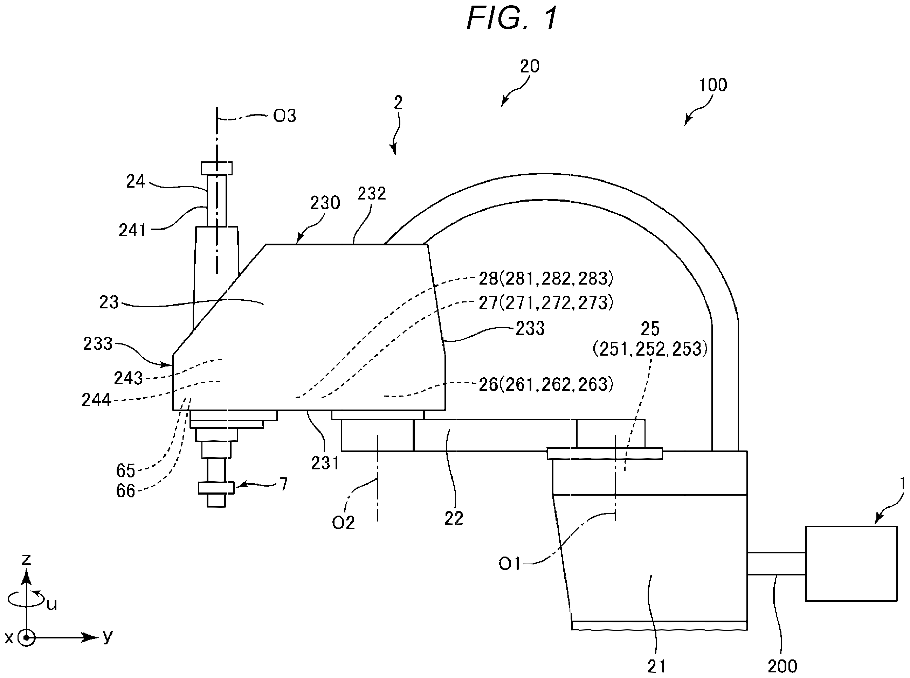

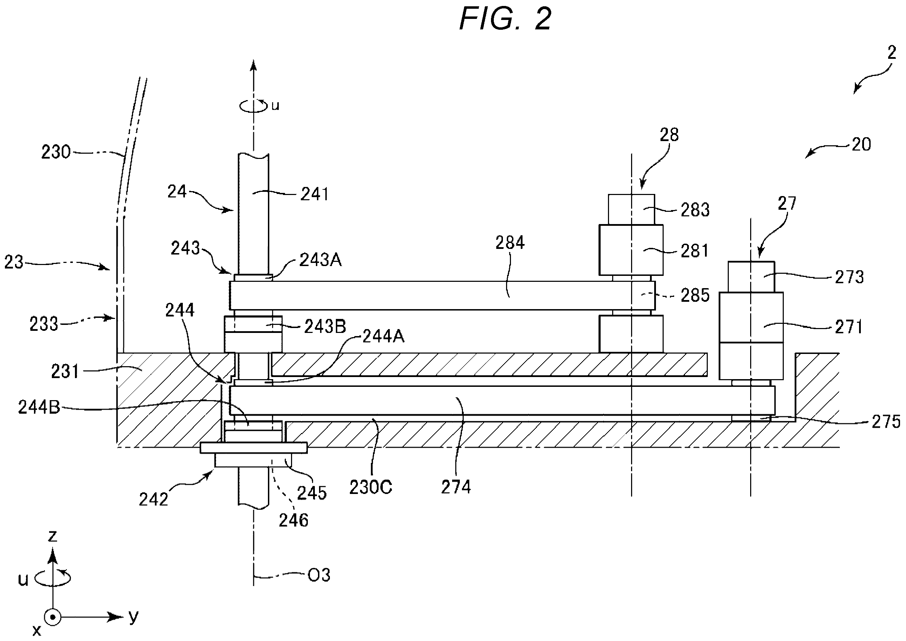

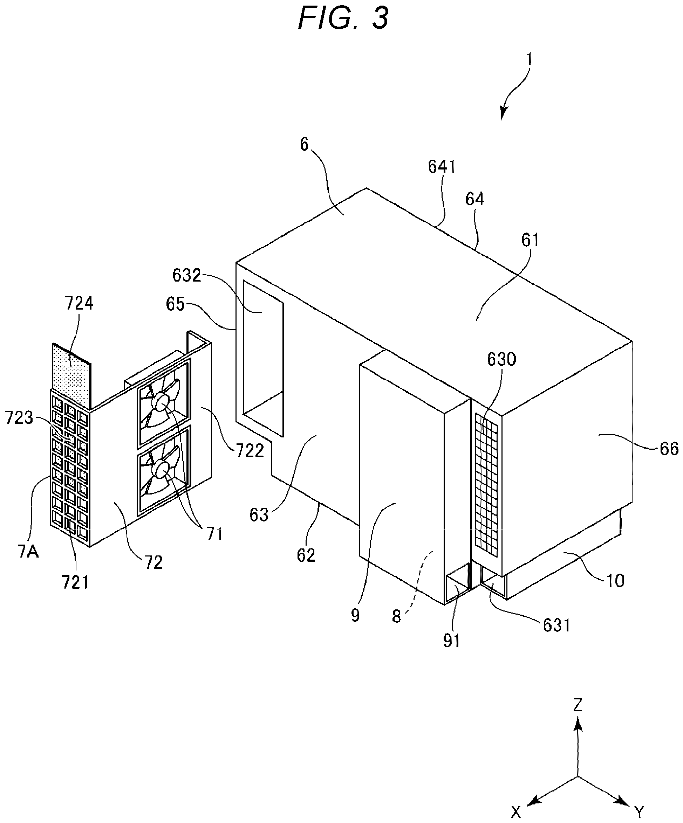

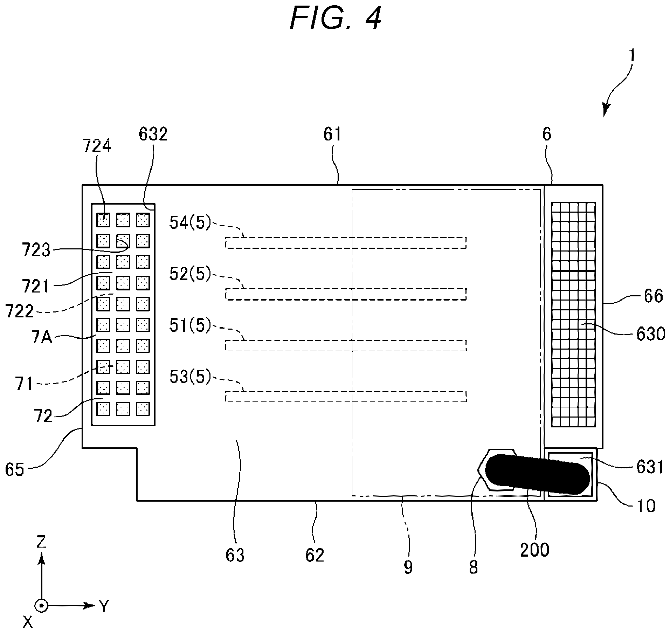

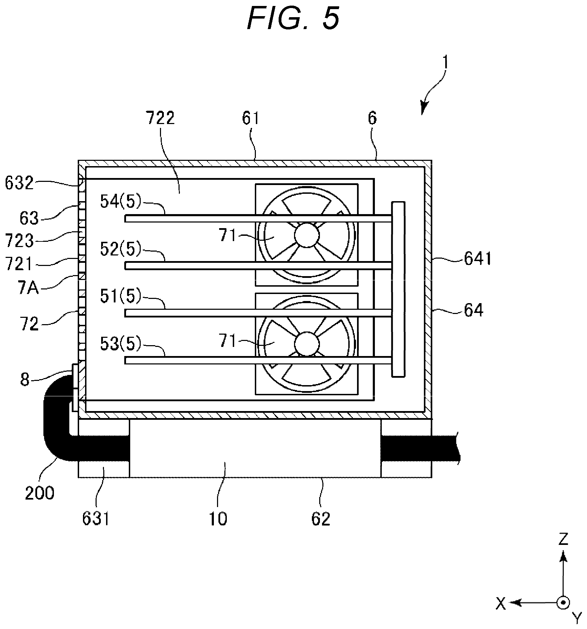

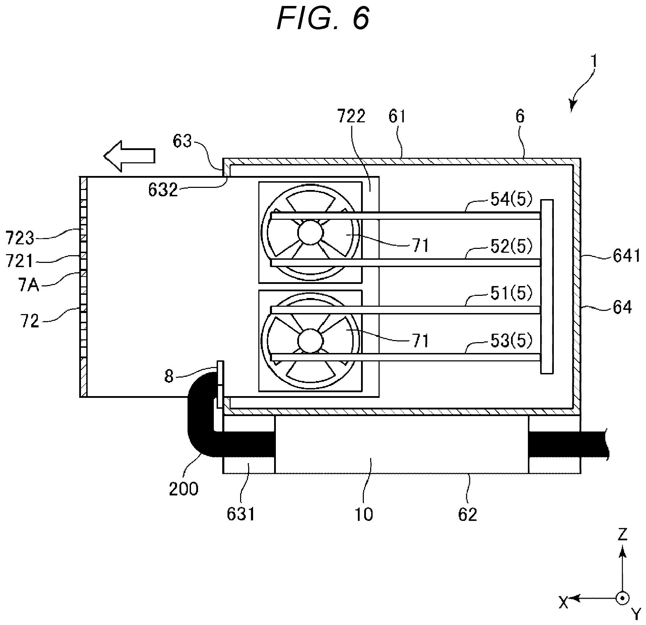

FIG. 1 is a side view showing a robot controlled by a robot control apparatus in a first embodiment of the present disclosure. FIG. 2 is a partial sectional view showing an interior of a second arm of a robot arm shown in FIG. 1. FIG. 3 is a perspective view of the robot control apparatus shown in FIG. 1. FIG. 4 is a front view of the robot control apparatus shown in FIG. 1. FIGS. 5 and 6 are partial sectional views of the robot control apparatus shown in FIG. 1.

In FIGS. 1 and 2, for convenience of explanation, as three axes orthogonal to one another, an x-axis, a y-axis, and a z-axis are shown. Further, hereinafter, directions parallel to the x-axis are also referred to as "x-axis directions", directions parallel to the y-axis are also referred to as "y-axis directions", and directions parallel to the z-axis are also referred to as "z-axis directions". Furthermore, hereinafter, head sides of the respective arrows are referred to as "+ (plus)" and tail sides are referred to as "- (minus)", the direction parallel to the +x-axis direction is also referred to as "+x-axis direction", the direction parallel to the -x-axis direction is also referred to as "-x-axis direction", the direction parallel to the +y-axis direction is also referred to as "+y-axis direction", the direction parallel to the -y-axis direction is also referred to as "-y-axis direction", the direction parallel to the +z-axis direction is also referred to as "+z-axis direction", and the direction parallel to the -z-axis direction is also referred to as "-z-axis direction". In addition, directions around the z-axis and directions around an axis parallel to the z-axis are also referred to as "u-axis directions".

In FIGS. 3 to 7, for convenience of explanation, as three axes orthogonal to one another, an X-axis, a Y-axis, and a Z-axis are shown. Further, hereinafter, directions parallel to the X-axis are also referred to as "X-axis directions", directions parallel to the Y-axis are also referred to as "Y-axis directions", and directions parallel to the Z-axis are also referred to as "Z-axis directions". Furthermore, hereinafter, head sides of the respective arrows are referred to as "+ (plus)" and tail sides are referred to as "- (minus)", the direction parallel to the +X-axis direction is also referred to as "+X-axis direction", the direction parallel to the -X-axis direction is also referred to as "-X-axis direction", the direction parallel to the +Y-axis direction is also referred to as "+Y-axis direction", the direction parallel to the -Y-axis direction is also referred to as "-Y-axis direction", the direction parallel to the +Z-axis direction is also referred to as "+Z-axis direction", and the direction parallel to the -Z-axis direction is also referred to as "-Z-axis direction".

Further, as below, for convenience of explanation, the +z-axis direction in FIG. 1 and the +Z-axis direction in FIG. 3, i.e., the upsides are also referred to as "upper" or "upward" and the -z-axis direction in FIG. 1 and the -Z-axis direction in FIG. 3, i.e., the downsides are also referred to as "lower" or "downward". With respect to a robot arm 20, a base 21 side in FIG. 1 is referred to as "proximal end" and the opposite side thereto, i.e., an end effector 7 side is referred to as "distal end". Furthermore, the z-axis directions in FIG. 1 and the Z-axis directions in FIG. 3, i.e., upward and downward directions are "vertical directions" and the x-axis directions and the y-axis directions in FIG. 1 and the X-axis directions and the Y-axis directions in FIG. 3, i.e., leftward and rightward directions are "horizontal directions".

A robot system 100 shown in FIG. 1 is a system used for e.g. work of holding, transport, assembly, inspection, etc. of workpieces for electronic components and electronic apparatuses. The robot system 100 includes a robot control apparatus 1, a robot 2, and an end effector 7.

The robot control apparatus 1 is placed in a position different from that of the robot 2, i.e., outside of the robot 2. Further, in the illustrated example, the robot 2 and the robot control apparatus 1 are electrically coupled (hereinafter, also simply referred to as "coupled") by a cable 200, however, not limited to that. The cable 200 may be omitted and wireless communications may be employed. That is, the robot 2 and the robot control apparatus 1 may be coupled by wired communications or coupled by wireless communications.

The robot 2 is a horizontal articulated robot, i.e., a scalar robot in the illustrated configuration.

As shown in FIG. 1, the robot 2 includes a base 21, a first arm 22, a second arm 23, and a third arm 24 as a working head. The first arm 22, the second arm 23, and the third arm 24 form a robot arm 20.

Further, the robot 2 includes a drive unit 25 rotating the first arm 22 relative to the base 21, a drive unit 26 rotating the second arm 23 relative to the first arm 22, a u drive unit 27 rotating a distal end shaft 241 of the third arm 24 relative to the second arm 23, and a z drive unit 28 moving the distal end shaft 241 in the z-axis directions relative to the second arm 23.

As shown in FIGS. 1 and 2, the drive unit 25 is provided within the base 21 and has a motor 251 generating a drive force, a reducer 252 reducing the drive force of the motor 251, and a position sensor 253 detecting a rotation angle of a rotation shaft of the motor 251 or the reducer 252.

The drive unit 26 is provided within a housing 230 of the second arm 23 and has a motor 261 generating a drive force, a reducer 262 reducing the drive force of the motor 261, and a position sensor 263 detecting a rotation angle of a rotation shaft of the motor 261 or the reducer 262.

The u drive unit 27 is provided within the housing 230 of the second arm 23 and has a motor 271 generating a drive force and a position sensor 273 detecting a rotation angle of a rotation shaft of the motor 271.

The z drive unit 28 is provided within the housing 230 of the second arm 23 and has a motor 281 generating a drive force and a position sensor 283 detecting a rotation angle of a rotation shaft of the motor 281.

As the motor 251, the motor 261, the motor 271, and the motor 281, e.g. servo motors such as AC servo motors or DC servo motors may be used.

As the reducer 252 and the reducer 262, e.g. planetary gear reducers, wave gearings, or the like may be used. Further, as the position sensor 253, the position sensor 263, the position sensor 273, and the position sensor 283, e.g. angle sensors may be used.

The drive unit 25, the drive unit 26, the u drive unit 27, and the z drive unit 28 are respectively coupled to corresponding motor drivers.

The base 21 is fixed to e.g. a floor surface (not shown) by bolts or the like. The first arm 22 is coupled to the upper end portion of the base 21. The first arm 22 is rotatable around a first axis O1 along the vertical directions relative to the base 21. When the drive unit 25 rotating the first arm 22 drives, the first arm 22 rotates within a horizontal plane around the first axis O1 relative to the base 21. Further, the rotation amount of the first arm 22 relative to the base 21 may be detected by the position sensor 253.

The second arm 23 is coupled to the distal end of the first arm 22. The second arm 23 is rotatable around a second axis O2 along the vertical directions relative to the first arm 22. The axial directions of the first axis O1 and the axial directions of the second axis O2 are the same. That is, the second axis O2 is parallel to the first axis O1. When the drive unit 26 rotating the second arm 23 drives, the second arm 23 rotates within a horizontal plane around the second axis O2 relative to the first arm 22. Further, the driving, specifically, the rotation amount of the second arm 23 relative to the first arm 22 may be detected by the position sensor 263. That is, the second axis O2 is a center of the output rotation shaft of the reducer 262.

The second arm 23 includes the housing 230 having a base portion 231, a top plate 232, and four side walls 233 coupling the base portion and the top plate as a plurality of wall portions. Inside of the housing 230, in other words, on the base portion 231, the drive unit 26, the u drive unit 27, and the z drive unit 28 are sequentially placed side by side from the +y-axis side.

Further, as shown in FIG. 2, the base portion 231 is a bottom portion of the second arm 23 and has a recessed part 230C in which the u drive unit 27 is placed. The recessed part 230C has a portion at the -z-axis side opened toward the -z-axis side, and a rotation supporting member 242 is provided within the opened portion and the distal end shaft 241 is inserted through the portion.

The third arm 24 is placed in the distal end portion of the second arm 23. The third arm 24 has the distal end shaft 241 and the rotation supporting member 242 rotatably supporting the distal end shaft 241.

The distal end shaft 241 is rotatable around a third axis O3 along the vertical directions and movable (elevatable) in the upward and downward directions relative to the second arm 23. That is, the distal end shaft 241 is a ball screw spline shaft and the distal end shaft 241 is an arm at the most distal end of the robot arm 20.

A ball screw nut 243 and a spline nut 244 are placed in the middle of the distal end shaft 241 in the longitudinal directions, and the distal end shaft 241 is supported by these nuts. These ball screw nut 243 and spline nut 244 are sequentially placed apart from the +z-axis side.

The ball screw nut 243 has an inner ring 243A and an outer ring 243B coaxially placed at the outer circumferential side of the inner ring 243A. A plurality of balls (not shown) are placed between these inner ring 243A and outer ring 243B, and the inner ring 243A and the outer ring 243B rotate relatively to each other with the movement of the balls.

The inner ring 243A has a portion exposed from the outer ring 243B and a belt 284, which will be described later, is looped over the exposed portion. Further, the distal end shaft 241 is inserted through, and the inner ring 243A supports the distal end shaft 241 movably along the z-axis directions as will be described later. The outer ring 243B is fixed to the base portion 231.

The spline nut 244 has an inner ring 244A and an outer ring 244B coaxially placed at the outer circumferential side of the inner ring 244A. A plurality of balls (not shown) are placed between these inner ring 244A and outer ring 244B, and the inner ring 244A and the outer ring 244B rotate relatively to each other with the movement of the balls.

The inner ring 244A has a portion exposed from the outer ring 244B and a belt 274, which will be described later, is looped over the exposed portion. Further, the distal end shaft 241 is inserted through, and the inner ring 244A supports the distal end shaft 241 rotatably around the z-axis, in the u-axis directions. The outer ring 244B is fixed to the recessed part 230C of the base portion 231, which will be described later.

The rotation supporting member 242 is placed at the -z-axis side of the spline nut 244. The rotation supporting member 242 has an outer tube 245 and a rotor 246 provided inside of the outer tube 245. The outer tube 245 is fixed to the base portion 231 within the housing 230 of the second arm 23. On the other hand, the rotor 246 is fixed to the distal end shaft 241 and supported by the outer tube 245 rotatably around the z-axis, in the u-axis directions with the distal end shaft 241.

When the u drive unit 27 rotating the distal end shaft 241 drives, the distal end shaft 241 forwardly and backwardly rotates around the z-axis. Further, the rotation amount of the distal end shaft 241 relative to the second arm 23 may be detected by the position sensor 273.

When the z drive unit 28 moving the distal end shaft 241 in the z-axis directions drives, the distal end shaft 241 moves in the upward and downward directions i.e., the z-axis directions. Further, the movement amount of the distal end shaft 241 in the z-axis directions relative to the second arm 23 may be detected by the position sensor 283.

Further, various end effectors are detachably coupled to the distal end portion of the distal end shaft 241. The end effectors are not particularly limited to, but include e.g. one gripping an object to be transported, one processing an object to be processed, and one used for an inspection. In the embodiment, the end effector 7 is detachably coupled.

Note that the end effector 7 is not a component element of the robot 2 in the embodiment, however, a part or all of the end effector 7 may be a component element of the robot 2. Further, the end effector 7 is not a component element of the robot arm 20 in the embodiment, however, a part or all of the end effector 7 may be a component element of the robot arm 20.

In the embodiment, the end effector 7 is detachable from the robot arm 20, however, not limited to that. For example, the end effector 7 is undetachable from the robot arm 20.

Next, the interior of the second arm 23 will be explained.

As shown in FIG. 2, in the robot 2, the u drive unit 27 rotating the third arm 24 around the z-axis, the z drive unit 28 moving the third arm 24 in the z-axis directions, the belt 274, and the belt 284 are provided within the housing 230 of the second arm 23.

As shown in FIG. 2, the u drive unit 27 has a pulley 275 in addition to the above described motor 271 and position sensor 273. These are placed from the +z-axis side in the order of the position sensor 273, the motor 271, and the pulley 275 and fixed to the bottom portion of the recessed part 230C. The pulley 275 is fixed to the rotation shaft of the motor 271 and the rotation force of the motor 271 is transmitted to the pulley 275.

Further, the pulley 275 is coupled to the inner ring 244A of the spline nut 244 provided in the distal end shaft 241 by the belt 274. The belt 274 is an endless belt looped over the pulley 275 and the inner ring 244A and has teeth (not shown) inside, i.e., the pulley 275 and inner ring 244A side. The teeth of the belt 274 respectively mesh with teeth (not shown) of the exposed portions of the pulley 275 and the inner ring 244A.

In the u drive unit 27, the rotation force of the motor 271 is transmitted to the belt 274 via the pulley 275 and the belt 274 rotates. By the rotation of the belt 274, the rotation force is transmitted to the distal end shaft 241 via the spline nut 244. The rotation force is transmitted to the distal end shaft 241 via the inner circumferential portion of the inner ring 244A and spline grooves (not shown) of the distal end shaft 241, and thereby, the distal end shaft 241 may move, in other words, rotate in the u-axis directions.

The z drive unit 28 has a pulley 285 in addition to the above described motor 281 and position sensor 283. These are placed from the +z-axis side in the order of the position sensor 283, the motor 281, and the pulley 285. The pulley 285 is fixed to the rotation shaft of the motor 281 and the rotation force of the motor 281 is transmitted to the pulley 285.

Further, the pulley 285 is coupled to the exposed portion of the inner ring 243A of the ball screw nut 243 provided in the distal end shaft 241 by the belt 284. The belt 284 is an endless belt looped over the pulley 285 and the inner ring 243A and has teeth (not shown) inside, i.e., the pulley 285 and inner ring 243A side. The teeth of the belt 284 respectively mesh with teeth (not shown) of the exposed portions of the pulley 285 and the inner ring 243A.

In the z drive unit 28, the rotation force of the motor 281 is transmitted to the belt 284 via the pulley 285 and the belt 284 rotates. By the rotation of the belt 284, the rotation force is transmitted to the distal end shaft 241 via the inner ring 243A of the ball screw nut 243. The direction of the rotation force is transformed by the inner circumferential portion of the inner ring 243A and ball screw grooves of the distal end shaft 241, and thereby, the distal end shaft 241 may move in the z-axis direction, in other words, move upward and downward.

As above, the robot 2 is briefly explained. Next, the robot control apparatus 1 will be explained.

As shown in FIGS. 3 to 6, the robot control apparatus 1 includes a control board 51, a power supply board 52 for supplying electric power to the control board 51, a drive control board 53 for drive control based on commands of the control board 51, a drive board 54 for driving the respective drive units based on the drive control by the drive control board 53, a housing 6 housing these boards, an air intake unit 7A, a cable coupling portion 8, a cover member 9, and a protective member 10. Hereinafter, the control board 51, the power supply board 52, the drive control board 53, and the drive board 54 are collectively referred to as "control boards 5".

The control board 51 has a control circuit (not shown) for controlling driving of the robot 2. The control circuit includes a processor such as a CPU, a volatile memory such as a RAM, and a nonvolatile memory such as a ROM and performs processing including control of driving of the respective units of the robot 2 and various calculations and determinations. For example, the control circuit can execute a predetermined control program and outputs a control signal to the control board 53 according to the control program to control the robot 2 to execute a predetermined motion.

The power supply board 52 has a power supply circuit (not shown) generating electric power respectively supplied to the control board 51 and the drive control board 53. The power supply circuit includes a transformer and a noise filter and, for example, transforms the frequency and the voltage of the electric power supplied from an external power supply (not shown) such as a commercial power source and supplies the power to the control board 51 and the drive control board 53.

The drive control board 53 receives the control signal from the control board 51 and generates a drive control signal for controlling the drive board 54 driving the respective drive unit 25 to drive unit 28.

The drive board 54 is a board on which a motor driver is mounted and receives the drive control signal from the drive control board 53 and drives motor drivers of the respective drive unit 25 to drive unit 28. The drive board 54 has drive circuits (not shown) for transformation to the electric power for supply to the respective drive unit 25 to drive unit 28. The drive circuit includes e.g. an inverter circuit (not shown) transforming from direct-current power to alternating-current power. Note that, in the illustrated configuration, the drive circuits for the respective drive unit 25 to drive unit 28 are provided on the single board, however, the drive circuits for the respective drive unit 25 to drive unit 28 may be separately provided on two or more boards.

The housing 6 is in a rectangular parallelepiped shape having a top plate 61, a bottom plate 62, a side wall 63, a side wall 64, a side wall 65, and a side wall 66. The top plate 61 includes a plate material having a thickness in the Z-axis directions. The bottom plate 62 includes a plate material having a thickness in the Z-axis directions. The side wall 63 includes a plate material located at the +X side and having a thickness in the X-axis directions. The side wall 64 includes a plate material located at the -X side and having a thickness in the X-axis directions. The side wall 65 includes a plate material located at the -Y side and having a thickness in the Y-axis directions. The side wall 66 is located at the +Y side and including a plate material having a thickness in the Y-axis directions. In the embodiment, the side wall 63 is a first plate material and the side wall 64 is a second plate material.

Note that, in the embodiment, the housing 6 is used in the orientation with the side wall 63 side as a front surface and the side wall 64 side as a back surface. Hereinafter, the outer surface of the side wall 64 is referred to as "back surface 641". Further, the back surface 641 is an installation surface at the -X-axis side in the side wall 64 facing an object on which the housing 6 is installed. As the object on which the housing 6 is installed is not particularly limited to, but includes a floor part, a wall part, and a ceiling. The installation surface is not limited to the back surface 641, but can be selected depending on the object on which the housing 6 is installed. That is, one of the outer surface of the top plate 61, the outer surface of the bottom plate 62, the outer surface of the side wall 64, and the outer surface of the side wall 65 may be used as the installation surface. Accordingly, when the outer surface of the top plate 61 is the installation surface, the top plate 61 is the second plate material, when the outer surface of the bottom plate 62 is the installation surface, the bottom plate 62 is the second plate material, when the outer surface of the side wall 64 is the installation surface, the side wall 64 is the second plate material, and, when the outer surface of the side wall 65 is the installation surface, the side wall 65 is the second plate material.

In an internal space surrounded by these top plate 61, bottom plate 62, side wall 63, side wall 64, side wall 65, and side wall 66, the control board 51, the power supply board 52, the drive control board 53, and the drive board 54 are placed apart from each other in parallel. As shown in FIGS. 5 and 6, in the embodiment, the control boards 5 are arranged in the order of the drive board 54, the power supply board 52, the control board 51, and the drive control board 53 from the +Z-axis side. These are supported by the inner surface of the side wall 64, i.e., the surface at the -X-axis side and placed in parallel to one another in the orientations with thicknesses in the Z-axis directions.

Further, as shown in FIGS. 3 and 6, the air intake unit 7A has fans 71 and a fan placement portion 72 in which the fans 71 are placed and is configured to be detachable from the housing 6.

In the embodiment, the two fans 71 are placed side by side in the Z-axis directions in the fan placement portion 72. The fan 71 has a rotary blade and is placed in the fan placement portion 72 in the orientation with the rotation shaft of the rotary blade along the Y-axis directions. Thereby, air may be blown from the -Y-axis side toward the +Y-axis side within the housing 6.

The fan placement portion 72 can be attached and detached by movement along the X-axis directions relative to an attachment and detachment hole 632 provided in the side wall 63 of the housing 6. The fan placement portion 72 has a first part 721 located in the opening of the attachment and detachment hole 632 in the attachment state and a second part 722 located within the housing in the attachment state.

The first part 721 is a plate material having an intake port 723 and forming a part of the side wall 63 in the attachment state. Further, a filter 724 is detachably placed in the intake port 723. By the filter 724, the air passing through the intake port 723 may catch dirt and dust.

The second part 722 includes a plate material extending from the edge portion at the +Y-axis side of the first part 721. In the second part 722, an attachment mechanism including a hook and a groove (not shown) is provided. Note that the second part 722 is not limited to the configuration, but may have e.g. a frame body in which an attachment mechanism including a hook and a groove is provided.

As described above, the robot control apparatus 1 includes the air intake unit 7A having the fans 71 and the fan placement portion 72 with the air intake port 723 formed therein and being detachable in the side wall 63 as the first plate material. Thereby, the air intake unit 7A as a whole may be detached from the housing 6 and replacement and maintenance of the fans 71 may be easily performed apart from the housing 6.

Further, when the air intake unit 7A is attached, the fans 71 are located inside of the housing 6 and the intake port 723 is located in the side wall 63 as the first plate material. Thereby, the air outside of the housing 6 may be taken into the housing 6 from the intake port 723 and the taken air may be blown within the housing 6.

The fans 71 are placed in the fan placement portion 72 in the orientations with the rotation shafts crossing, in the embodiment, orthogonal to the direction in which the air intake unit 7A is inserted or pulled out. Thereby, the air taken into the housing 6 from the intake port 723 may be efficiently circulated within the entire housing 6.

As shown in FIGS. 3 and 4, an exhaust port 630 is provided in the side wall 63. The exhaust port 630 has a function of exhausting the air within the housing 6 to the outside. The exhaust port 630 is formed in a position closer to the +Y-axis side of the side wall 63. Further, the exhaust port 630 has an elongated shape extending along the Z-axis directions.

The air taken from the intake port 723 is blown toward the +Y-axis side by the fans 71 and collides with the inner surface of the side wall 66. Then, the air is blown toward the exhaust port 630, in other words, changes the path thereof and is blown toward the +X-axis side and exhausted from the exhaust port 630. By the above described air flow, the control boards 5 may be efficiently cooled.

As shown in FIGS. 3 to 5, the cable coupling portion 8 coupling the cable 200 for communication with the robot 2 is provided in the side wall 63. The cable coupling portion 8 is a coupling portion at a standard corresponding to the configuration of the end portion of the cable 200. The control boards 5 and the robot 2 are electrically coupled via the cable 200 coupled to the cable coupling portion 8. The cable coupling portion 8 is provided in a position closer to the -Z-axis side and the +Y-axis side of the side wall 63.

Further, the cable coupling portion 8 is covered by the cover member 9. The cover member 9 is detachably attached to the side wall 63 and attached to cover at least the cable coupling portion 8. The cover member 9 has a relief hole 91 through which the cable 200 coupled to the cable coupling portion 8 is inserted. Thereby, even when the cable coupling portion 8 is attached to the side wall 63, an interference between the cover member 9 and the cable 200 may be avoided.

Note that, in the cable coupling portion 8, the cable 200 is inserted from the +X-axis side in the illustrated configuration, however, may be inserted from the +Y-axis side.

In the embodiment, the cable 200 coupled to the cable coupling portion 8 is routed from the side wall 66 side toward the -X-axis side. As shown in FIG. 5, a cutout portion 631 is provided in the housing 6. The cutout portion 631 with a corner portion at the +Y-axis side and the -Z-axis side cut out in the side wall 63 is provided in the entire part in the X-axis directions in the side wall 66. The cable 200 may be held within the cutout portion 631.

Further, as shown in FIG. 5, the protective member 10 is attached to the cutout portion 631. The protective member 10 has a function of covering the cutout portion 631 apart from the inner surface of the cutout portion 631 and protecting the inserted cable 200. The length of the protective member 10 in the X-axis directions is shorter than the length of the housing 6 in the X-axis directions. Thereby, an interference between a part of the cable 200 not held within the cutout portion 631, particularly, near the ends at the +X-axis side and the - X-axis side of the cutout portion 631 and the protective member 10 may be avoided.

As described above, the housing 6 has the cutout portion 631 cut out in a plan view as seen from the thickness directions of the side wall 63 as the first plate material, and the protective member 10 protecting the cable 200 is provided in the cutout portion 631. Thereby, the cable 200 may be protected and the position of the cable 200 within the cutout portion 631 may be restricted.

Further, the length of the protective member 10 in the directions along the thickness directions of the side wall 63 as the first plate material is shorter than the length of the housing 6 in the directions along the thickness directions of the side wall 63. Thereby, an interference between a part of the cable 200 not held within the cutout portion 631, particularly, near the ends at the +X-axis side and the -X-axis side of the cutout portion 631 and the protective member 10 may be avoided.

Here, in related art, in the robot control apparatus, the intake port, the exhaust port, and the cable coupling portion are discretely placed in the housing. That is, the intake port, the exhaust port, and the cable coupling portion are not collectively provided. Accordingly, there are more restrictions in the location where the housing is installed. For example, when the intake port is provided in the front surface of the housing, the exhaust port is provided in the side surface of the housing, and the cable coupling portion is provided in the back surface of the housing, it may be impossible to place the side surface with the exhaust port provided therein and the back surface with the cable coupling portion provided therein in close contact with the surface on which the robot control apparatus is installed and a wall around the surface, and there are more restrictions in the installation location. On the other hand, in the present disclosure, the intake port 723, the exhaust port 630, and the cable coupling portion 8 are collectively provided in the side wall 63. In other words, the intake port 723, the exhaust port 630, and the cable coupling portion 8 are not provided in other parts than the side wall 63. According to the configuration, the apparatus may be installed so that at least one side wall of the side wall 64, the side wall 65, and the side wall 66 may be placed in close contact with a surrounding wall or the like. Therefore, there are less restrictions in the installation position than those in related art and the degree of freedom of the installation position is higher.

As described above, the robot control apparatus 1 controls the robot 2 and includes the control boards 5 controlling the operation of the robot 2, the housing 6 including the plurality of plate materials containing the side wall 63 as the first plate material and the side wall 64 as the second plate material and housing the control boards 5 in the space surrounded by the plurality of plate materials, the intake port 723 for taking the air into the housing 6, the exhaust port 630 for exhausting the air within the housing 6 to the outside, and the cable coupling portion 8 coupling the cable 200 for communication with the robot 2. Further, the intake port 723, the exhaust port 630, and the cable coupling portion 8 are provided in the side wall 63, and the side wall 64 includes the installation surface facing the object on which the housing 6 is installed. Thereby, the apparatus may be installed so that the other parts than the side wall 63 may be placed in close contact with the surrounding wall or the like. Therefore, the degree of freedom of the installation position may be increased.

Furthermore, as shown in FIG. 4, as seen from the thickness directions of the side wall 63 as a plate part, i.e., the X-axis directions, the control boards 5 are located between the intake port 723 and the exhaust port 630. Thereby, the control boards 5 may be effectively cooled by an air flow formed between the intake port 723 and the exhaust port 630 within the housing 6.

### Second Embodiment

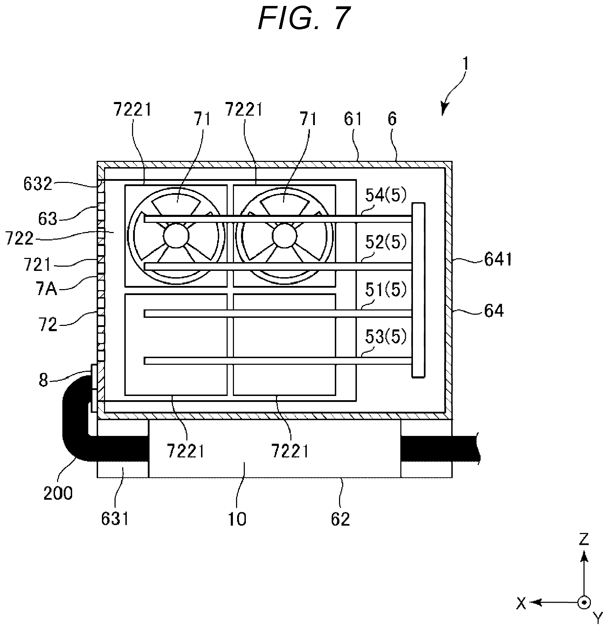

FIG. 7 is a partial sectional view of a robot control apparatus according to a second embodiment of the present disclosure.

As below, the second embodiment of the robot control apparatus according to the present disclosure will be explained with reference to the drawing, and the differences from the first embodiment will be explained.

As shown in FIG. 7, in the embodiment, the two fans 71 are placed side by side in the axial directions of the X-axis relative to the second part 722 of the fan placement portion 72 of the air intake unit 7A. Further, the two fans 71 are located at the +Z-axis side of the housing 6 and placed to overlap with the drive board 54 and the power supply board 52 as seen from the axial directions of the Y-axis. According to the configuration, the air blown by the fans 71 may be concentrated onto the drive board 54 and the power supply board 52. Of the control boards 5, heat is especially generated in the drive board 54 and the power supply board 52, and those boards may be concentratively cooled.

Further, as shown in FIG. 7, in the embodiment, four holes 7221 in which the fans 71 can be placed are provided in the second part 722. In the second part 722, attachment mechanisms including hooks and grooves (not shown) are provided in positions corresponding to the four holes 7221. Accordingly, the two fans 71 are placed in the holes 7221 provided at the +Z-axis side using the attachment mechanisms corresponding to the holes 7221 provided at the +Z-axis side.

Therefore, in the embodiment, the placement positions where the fans 71 are placed can be adjusted. That is, the holes can be selected from the four holes 7221 for placement of the fans 71. According to the configuration, the placement positions of the fans 71 may be adjusted according to the placements of the control boards 5, and thereby, the control boards 5 may be efficiently cooled.

As described above, the positions of the fans 71 with respect to the control boards 5 in the attachment state of the air intake unit 7A can be adjusted. Thereby, the parts desired to be cooled of the control boards 5 may be concentratively cooled.

Note that, in the embodiment, the configuration in which the intake port 723, the exhaust port 630, and the cable coupling portion 8 are provided in the side wall 63 is explained, however, the present disclosure is not limited to that. For example, the intake port 723, the exhaust port 630, and the cable coupling portion 8 may be collectively provided in one plate material of the top plate 61, the bottom plate 62, and the side wall 64 to side wall 66. Or, an indicator lamp may be further collectively provided in the plate material in which the intake port 723, the exhaust port 630, and the cable coupling portion 8 are collectively provided.

Further, in the embodiment, the control boards 5 are arranged in the order of the drive board 54, the power supply board 52, the control board 51, and the drive control board 53 from the +Z-axis side, however, not limited to that. The order of the control boards 5 may be appropriately changed.

Furthermore, in the embodiment, the housing 6 is explained by taking the box-shaped one including the six plate materials as the example, however, the present disclosure is not limited to that. For example, a shape in which at least two of the six plate materials forming a continuous curved surface may be employed.

As above, the robot control apparatus according to the present disclosure is explained based on the illustrated embodiments, however, the present disclosure is not limited to those. The configurations of the respective units may be replaced by any configurations having the same functions. Further, any other configuration may be added.

In the above described embodiments, the number of the rotation shafts of the robot arm is three, however, the present disclosure is not limited to that. The number of the rotation shafts of the robot arm may be e.g. two, four, or more. That is, in the above described embodiments, the number of the arms is three, however, the present disclosure is not limited to that. The number of the arms may be e.g. two, four, or more.

## Claims

1. A robot control apparatus controlling a robot, comprising:
a control board for controlling operation of the robot;
a housing including a plurality of plate materials containing a first plate material and a second plate material, and housing the control board;
an intake port for taking air into the housing;
an exhaust port for exhausting the air within the housing to outside; and
a cable coupling portion coupling a cable for communication with the robot, wherein
the intake port, the exhaust port, and the cable coupling portion are provided in the first plate material, and
the second plate material includes an installation surface facing an object on which the housing is installed.

2. The robot control apparatus according to claim 1, further comprising an air intake unit having a fan and a fan placement portion in which the intake port is formed and being detachable in the first plate material.

3. The robot control apparatus according to claim 2, wherein
when the air intake unit is attached, the fan is located inside of the housing and the intake port is located in the first plate material.

4. The robot control apparatus according to claim 2, wherein
the fan is placed in the fan placement portion in an orientation with a rotation shaft crossing a direction in which the air intake unit is inserted or pulled out.

5. The robot control apparatus according to claim 2, wherein
a position of the fan with respect to the control board in an attachment state of the air intake unit is adjustable.

6. The robot control apparatus according to claim 1, wherein
the control board is located between the intake port and the exhaust port in a plan view as seen from a thickness direction of the first plate material.

7. The robot control apparatus according to claim 1, wherein
the housing has a cutout portion cut out in a plan view as seen from a thickness direction of the first plate material, and
a protective member protecting the cable is provided in the cutout portion.

8. The robot control apparatus according to claim 7, wherein
a length of the protective member in a direction along the thickness direction of the first plate material is shorter than a length of the housing in the direction along the thickness direction of the first plate material.
